# EUROPEAN PATENT APPLICATION

(11) **EP 2 372 786 A1**
(43) Date of publication of application: **05.10.2011**
(21) Application number: 10003493.3
(22) Date of filing: 30.03.2010
(51) Int. Cl.: H01L 31/055, H01L 31/048, H01L 31/0216

(54) **Wavelength spectrum conversion solar cell module**

(71) Applicant: ACPA Energy Conversion Devices Co., Ltd., Jhonghe City (Taipei County 23552) (TW)
(72) Inventor: Yao, Pei-Chih, Jhonghe City (Taipei County 23552) (TW)
(74) Representative: Zeitler, Giselher

(57) **Abstract**

An optical total internal reflection wavelength conversion solar cell module 1 includes a solar cell 10, a wavelength spectrum conversion layer 12 having a wavelength spectrum conversion effect and being coupled to a side of the solar cell 10, and a cover panel 20 for packaging the solar cell 10 and the wavelength spectrum conversion layer 12, such that the wavelength of a light source which have a less solar cell photoelectric conversion efficiency or the wavelength of an unuseful light source into the wavelength of a more useful light source wavelengh spectrum domain and to increase the probability for the solar cell 10 to receive sunlight, so as to enhance the light source utility efficiency and achieve a much better conversion efficiency.

## Description

### BACKGROUND OF THE INVENTION

### 1. Field of the Invention

The present invention relates to a wavelength spectrum conversion solar cell module, and more particularly to a wavelength spectrum conversion solar cell module capable of converting the wavelength spectrum of a light source incident to a solar cell which have a less photoelectric conversion efficiency or an unuseful light source wavelength spectrum into the wavelength spectrum of a more useful light source wavelength spectrum domain, and to increase the probability for the solar cell to receive sunlight, so as to enhance the light source utility efficiency and achieve a much better conversion efficiency.

### 2. Description of the Related Art

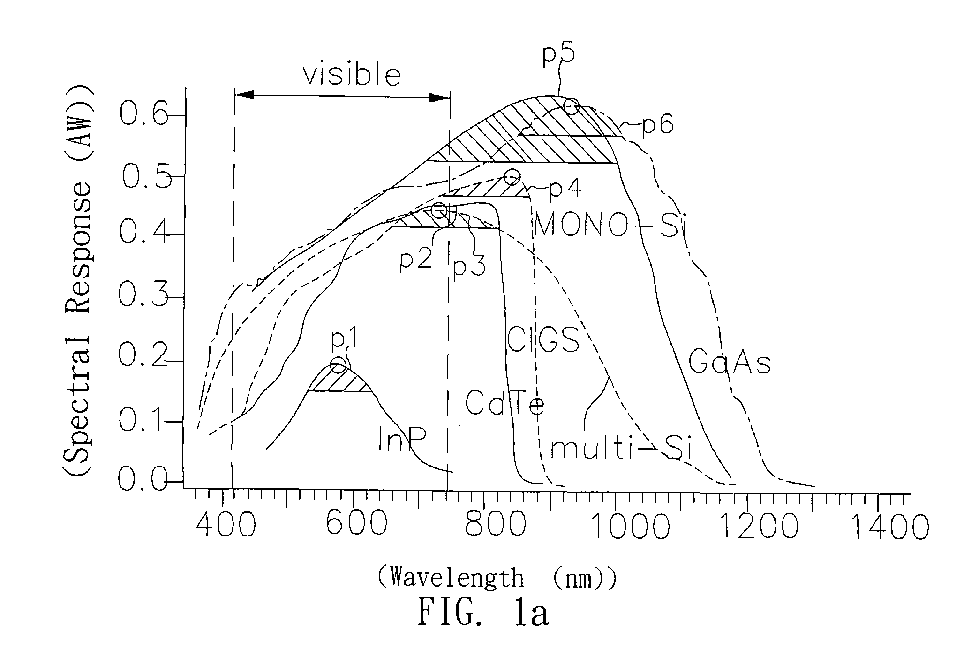

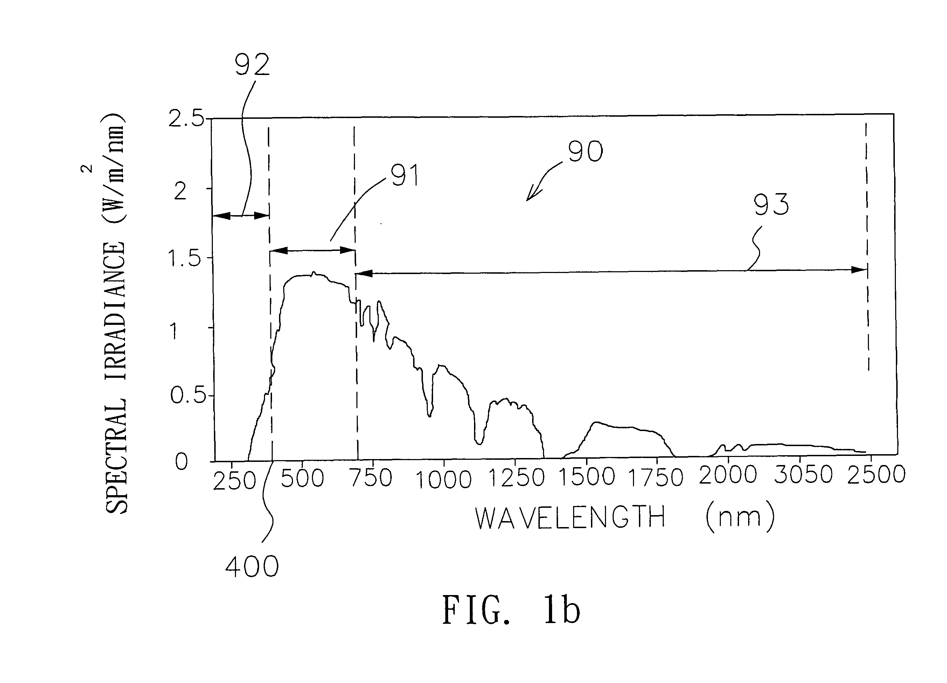

As the issue of energy shortage becomes increasingly more serious, green light energy technologies become an important subject for the research and development of present energy sources. For example, solar energy is used more extensively now, and various different solar cells have different responses to the wavelength spectrum of a light source due to various different photoelectric materials of the solar cells. With reference to FIG. 1a for a graph of spectral response versus wavelength spectrum of sunlight in accordance with a prior art, the x-axis represents the wavelength spectrum of a light source (such as sunlight), and the y-axis represents the photoelectric response efficiency for the wavelengths of the light source with respect to different photoelectric materials. In the graph, the closer the value falling within a peak value range P1∼P6, the higher is the response efficiency. However, the utility efficiency of the photoelectric conversion effect can be enhanced significantly, if the solar cell can convert the sunlight having a wavelength spectrum of a light source having no response or very low wavelength spectrum response efficiency into the maximum wavelength responsivity spectrum domain of the light source. With reference to FIG. 1b for a graph of spectral irradiance versus wavelength of sunlight in accordance with a prior art, a sunlight spectrum 90 is divided into three light source sections arranged in an ascending order of their wavelengths, respectively: an ultraviolet section 92, a visible section 91 and an infrared section 93, wherein areas adjacent to the visible light section 91 and the infrared light section 93 are the light source wavelength sections with the better response efficiency of the most of solar cell, and thus it is an important research and development subject and breakthrough for the related industry to produce the best response efficiency of the sunlight spectrum 90 to the solar cell in order to enhance the utilization rate and irradiance of the sunlight source and achieve the best photoelectric conversion efficiency when the sunlight enters into the conversion solar cell module.

In view of the shortcomings of the conventional conversion solar cell module having a low conversion efficiency and a poor structural design, the inventor of the present invention based on years of experience in the related industry to conduct extensive researches and experiments, and finally developed a more efficient and economic optical total internal reflection wavelength spectrum conversion solar cell module in accordance with the present invention.

### SUMMARY OF THE INVENTION

Therefore, it is a primary objective of the present invention to overcome the aforementioned shortcoming and deficiency of the prior art by providing an optical total internal reflection wavelength spectrum conversion solar cell module capable of converting the wavelength spectrum of a light source having a less solar cell photoelectric conversion efficiency or an unuseful light source into the wavelength spectrum of a useful light source in order to increase both the conversion efficiency and probability for the solar cell to receive sunlight, and enhance the utilization efficiency and achieve an excellent conversion efficiency of the light source.

To achieve the foregoing objective, the present invention provides a wavelength spectrum conversion solar cell module comprising: a solar cell; a wavelength spectrum conversion layer, having a wavelength conversion effect, wherein the wavelength spectrum conversion layer is coupled to a side of the solar cell; and a cover panel, for packaging the solar cell and the wavelength spectrum conversion layer.

The wavelength spectrum conversion solar cell module of the present invention further comprises: a solar cell; a cover panel, for packaging the solar cell; and a plurality of wavelength spectrum conversion layers, having a wavelength conversion effect, wherein the wavelength conversion layers are coupled to a side of the solar cell and disposed on at least an external side of the cover panel.

The present invention futher comprises: a solar cell; a cover panel, for packaging the solar cell; a wavelength spectrum conversion layer, having a wavelength conversion effect, wherein the wavelength spectrum conversion layer is coupled to a side of the solar cell; an anti-reflection layer, reduce or avoid the reflection of the light source illuminating the surface of the solar cell, is couple to the outer surface of the cover panel.

The present invention futher comprises: a solar cell; a cover panel, for packaging the solar cell; a wavelength spectrum conversion layer, having a wavelength conversion effect, wherein the wavelength spectrum conversion layer is coupled to a side of the solar cell; an anti-reflection layer, reduce or avoiding the wavelength spectrum leakage effect afetr the sunlight is projected onto the surface of the solar cell, is couple to the outer surface of the cover panel, and to increase the probability and the responsivity for the wavelength spectrum conversion layer to receive and convert all of or most of sunlight, so as to enhance and achieve a much better light source conversion efficiency

The technical characteristics of the present invention will become apparently with the detailed description of the preferred embodiments and the illustration of the related drawings.

### BRIEF DESCRIPTION OF THE DRAWINGS

FIG. 1a is a graph of spectral response of different solarcell material's systems versus wavelength spectrum responsivity of sunlight in accordance with a prior art;
FIG. 1b is a graph of spectral irradiance versus wavelength of sunlight in accordance with a prior art;
FIG. 2 is a schematic view of a first preferred embodiment of the present invention;
FIG. 3 is a schematic view of operating a wavelength modulation in accordance with a first preferred embodiment of the present invention;
FIG. 4 is a first schematic view of a second preferred embodiment of the present invention;
FIG. 5 is a second schematic view of a second preferred embodiment of the present invention;
FIG. 6 is a first schematic view of a third preferred embodiment of the present invention; and
FIG. 7 is a second schematic view of a third preferred embodiment of the present invention.

### DETAILED DESCRIPTION OF THE PREFERRED EMBODIMENTS

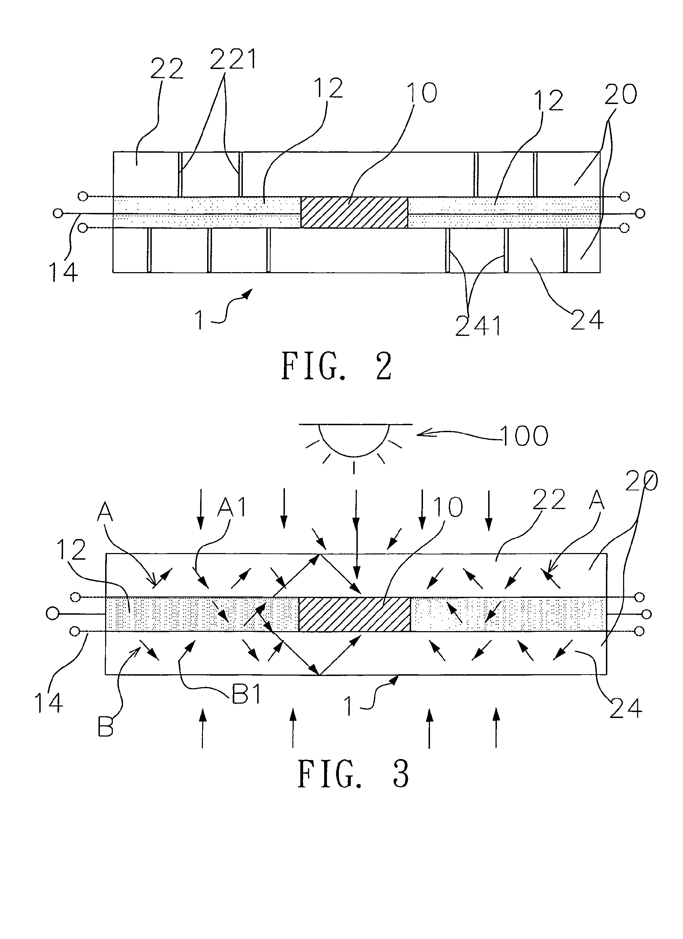

With reference to FIG. 2 for a schematic view of an optical total internal reflection wavelength spectum conversion solar cell module in accordance with a first preferred embodiment of the present invention, the conversion solar cell module 1 comprises: a solar cell 10, wherein the solar cell 10 is a single-sided solar cell, a double-sided solar cell, or a combination of several solar cells arranged on the same plane; a wavelength spectrum conversion layer 12 disposed substantially parallel to a lateral side of the solar cell 10, wherein the wavelength spectrum conversion layer 12 is made of a polymer material or a glass substrate material, including a wavelength modulation material (such as a composite of an organic wavelength modulation material, a quantum-dot wavelengh modulation material, and a nano-particle light intensity enhancing powder), or a grating or a optical lens constructed by the aforementioned wavelength modulation materials, such that the wavelength spectrum conversion layer has the optical functions such as the wavelength spectrum conversion, the optical reflection refraction, diffraction, filtering or focusing. In this preferred embodiment, the wavelength conversion layer 12 is coupled to a side of the solar cell 10. In other words, the wavelength conversion layer 12 is coupled to a side of the solar cell 10 or around the solar cell 10, and then the entire solar cell is packaged by a cover panel 20, wherein the cover panel 20 includes an upper cover panel 22 and a lower cover panel 24, and the upper cover panel 22 and the lower cover panel 24 are made of glass, acrylic (PMMA), epoxy resin, silicone rubber, silicone gel, polymer material (e.g. EVA, Tedlar) or a composite or a combination of a plurality of layers of the aforementioned materials. In addition, an electrode 14 such as an electrode grid is installed between the upper cover panel 22 and the lower cover panel 24, and the electrode 14 is coupled to the solar cell 10. The upper cover panel 22 and the lower cover panel 24 further include a plurality of package ventilation holes 221, 241, for providing the trapped air bubbles a ventilation function during packaging process, as well as providing a channel for wiring the electrode 14.

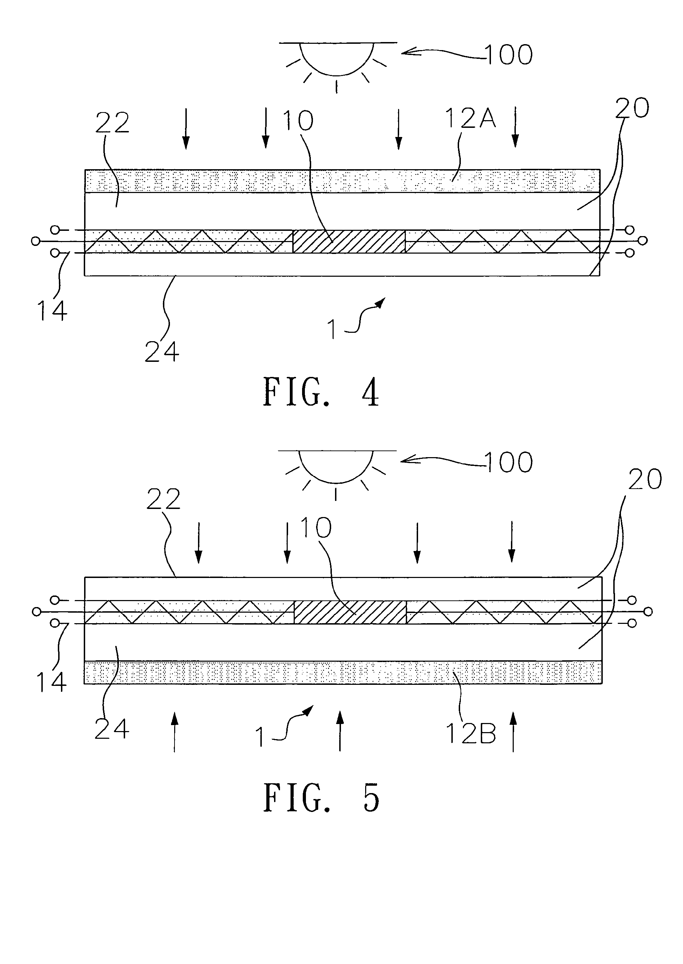

With reference to FIG. 3, if sunlight enters into the conversion solar cell module 1 from both sides of the surface of the conversion solar cell module 1, a light A or light B is passed through the upper cover panel 22 and projected onto the wavelength spectrum conversion layer 12, and then the light A (a vast majority or a portion of the light A) travels in a light path Al with a total internal reflection between the upper cover panel 22 and the lower cover panel 24, and finally the light A is projected onto the solar cell 10. Since the wavelength spectrum conversion layer 12 has a function of converting the wavelength spectrum of the sunlight, therefore the unuseful wavelength of the light source (the light A) projected onto the wavelength conversion layer 12 can be converted into the wavelength spectrum of the light source that can be absorbed and used more efficiently by the solar cell 10. In other words, the total reflection of the light source reflected from both the upper cover panel 22 and lower cover panel 24 inside the conversion solar cell module 1 can be used for providing a spectrum with a maximum response efficiency for the sunlight source wavelength modulation of the solar cell 10 to improve the light energy conversion efficiency of the conversion solar cell module 1 significantly. With reference to FIG. 4 for a schematic view of an optical total internal reflection wavelength spectrum conversion solar cell module in accordance with a second preferred embodiment of the present invention, the wavelength conversion layer 12 is laminated not only in the between of cover panels 20 but also coated at a top side (or an external side) of the upper cover panel 22 of the conversion solar cell module 1, such that the wavelength spectrum conversion layer 12A can be provided for modulating the wavelength of the light source of the sunlight entered at the first stage. With reference to FIG. 5, the wavelength spectrum conversion layer 12B is laminated not only in the between of cover panels 20 but also coated at a bottom side (or an external side) of the lower cover panel 24, such that the wavelength spectrum conversion layer 12B can be provided for modulating the wavelength of the light source of the sunlight entered at the first stage and performing a total internal reflection.

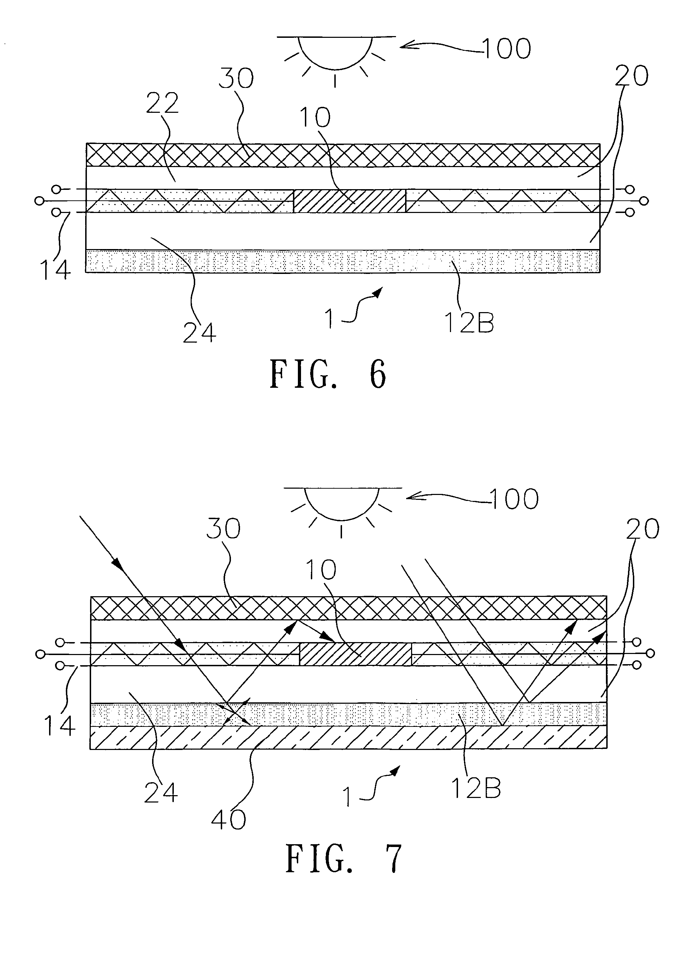

With reference to FIG. 6 for a schematic view of an optical total internal reflection wavelength spectrum conversion solar cell module in accordance with a third preferred embodiment of the present invention, the conversion solar cell module 1 is packaged independently, and an anti-reflection coating 30 which is a thin film, is coated at a top side (or an external side) of the cover panel 20, such that when the sunlight 100 is projected onto the conversion solar cell module 1, the sunlight 100 enters into the conversion solar cell module 1 through the anti-reflection coating 30 and the anti-reflection coating 30 is provided for reducing or avoiding the surface reflection effect when the sunlight 100 is projected onto the conversion solar cell module 1. As a result, a vast majority or a portion of the sunlight 100 will enter into the conversion solar cell module 1 to improve the probability for the solar cell 10 to receive the sunlight; In addition, a wavelength spectrum conversion layer12B can also be coated at a bottom side (or an external side) of cover panel 20.

With reference to FIG. 7, the fouth preferred embodiment of the present invention, after packing the conversion solar cell module 1 singlarly, the bottom side (or external side) of cover panel 20 further includes a reflective coating 40, which is a thin film, such that when the sunlight 100 is projected onto the conversion solar cell module 1, the light entering into the conversion solar cell module 1 can be reflected from the reflective coating 40 and a wavelength spectrum modulation is performed continuously by the wavelength spectrum conversion layer 12B to reduce or avoid a leakage after the sunlight 100 is projected onto the conversion solar cell module, so as to provide a maximum responsivity of wavelength spectrum modulation of the majority or part of the sunlight 100 and enhance the light energy conversion efficiency; in addition, a wavelength spectrum conversion layer 12B can also be.coated between the cover panel 20 and the reflective coating 40.

With the optical total internal reflection wavelength spectrum conversion solar cell module of the present invention, the sunlight in the conversion solar cell module 1 can be projected onto the solar cell with a higher probability to provide sufficient conversion response to convert less useful wavelengths of a light source into better wavelengths response domain of the solar cell to enhance the utility efficiency of the light source.

In summation of the description above, the present invention improves over the prior art and complies with patent application requirements, and thus is duly filed for the patent application. While the invention has been described by device of specific embodiments, numerous modifications and variations could be made thereto by those generally skilled in the art without departing from the scope and spirit of the invention set forth in the claims.

## Claims

1. An optical total internal reflection wavelength spectrum conversion solar cell module 1, comprising:
a solar cell 10;
at least a wavelength spectrum conversion layer 12, having a wavelength spectrum conversion effect, and a side of the wavelength spectrum conversion layer 12 being coupled to the solar cell 10; and
a cover panel 20, for packaging the solar cell 10 and at least one of the wavelength spectrum conversion layers 12.

2. The optical total internal reflection wavelength spectrum conversion solar cell module 1 of claim 1, wherein the solar cell 10 is a single-sided solar cell,or a double-sided solar cell, or an array formed by combination of a plurality of solar cells on same plane in parallel.

3. The optical total internal reflection wavelength spectrum conversion solar cell module 1 of claim 1, wherein the wavelength spectrum conversion layer 12 is coated on glass panel or mixed with a polymer , and its composition includes an organic wavelength modulation material, a quantum-dot wavelengh modulation material and a nano-particle light intensity enhancing powder, or formed as a grating or an optical lens constructed by a combination of the aforesaid wavelength modulation materials, such that the wavelength spectrum conversion layer 12 has optical functions of a wavelength spectrum conversion, an optical reflection , refraction, diffraction, filtering or focusing.

4. The optical total internal reflection wavelength conversion solar cell module 1 of claim 1, wherein the wavelength conversion layer 12 includes an electrode wiring 14 installed inside or between interfaces of the cover panel 20 and coupled to the solar cell 10.

5. The optical total internal reflection wavelength spectrum conversion solar cell module 1 of claim 1, wherein the cover panel 20 is made of a transparent material selected from the collection of glass, PMMA, epoxy resin, silicone rubber, silicone gel, polymer and a composite of the above materials.

6. The optical total internal reflection wavelength conversion solar cell module 1 of claim 1, wherein the cover panel 20 further includes a plurality of package air bubbles ventilation holes 221, 241 respectively.

7. The optical total internal reflection wavelength conversion solar cell module 1 of claim 1, wherein an anti-reflection coating 30 is coated at a top side of the cover panel 20.

8. The optical total internal reflection wavelength conversion solar cell module 1 of claim 7, wherein a wavelength spectrum layer 12 is coated or lamilated on a bottom side of the cover panel 20.

9. The optical total internal reflection wavelength conversion solar cell module 1 of claim 1, wherein an anti-reflection coating 30 is coated or lamilated on at a bottom side of the cover panel 20

10. The optical total internal reflection wavelength conversion solar cell module 1 of claim 9, wherein a wavelength spectrum layer 12 is laminated in the between of the bottom side cover panel 20 and anti-reflection coating 30.

11. An optical total internal reflection wavelength spectrum conversion solar cell module 1, comprising:
a solar cell 10;
a cover panel 20, for packaging the solar cell 10;
a plurality of wavelength conversion layers 12, having a wavelength spectrum conversion effect, and the wavelength spectrum conversion layer 12 being disposed at both internal and at least an external side of the cover panel 20 respectively.

12. The optical total internal reflection wavelength conversion solar cell module 1 of claim 11, wherein thesolar cell 10 is a single-sided solar cell, a double-sided solar cell, or an array of combination of plural solar cells on same plane in paralell.

13. The optical total internal reflection wavelength conversion solar cell module 1 of claim 11, whereinthe wavelength spectrum conversion layer 12 is coated on glass panel or mixed with a polymer with composition includes an organic wavelength modulation material, a quantum-dot wavelengh modulation material and a nano-particle light intensity enhancing powder, or a grating or a optical lens constructed by a combination of the aforesaid wavelength modulation materials, such that the wavelength spectrum conversion layer 12 has optical functions of a wavelength spectrum conversion, an optical reflection ,refraction, diffraction, filtering or focusing .

14. The optical total internal reflection wavelength conversion solar cell module 1 of claim 11, wherein the wavelength conversion layer 12 includes an electrode wiring 14 installed inside or between interfaces of the cover panel 20 and coupled to the solar cell 10.

15. The optical total internal reflection wavelength conversion solar cell module 1 of claim 11, wherein the cover panel 20 is made of a transparent material selected from the collection of glass, PMMA, epoxy resin, silicone rubber, silicone gel, polymer and a composite of the above materials.

16. The optical total internal reflection wavelength conversion solar cell module 1 of claim 11, wherein the cover panel 20 further includes a plurality of package air bubbles ventilation holes 221, 241 respectively.
